# FASCICULE DE BREVET EUROPEEN

(11) **EP 3 339 392 B1**
(45) Date de publication et mention de la délivrance du brevet: **11.12.2019**
(21) Numéro de dépôt: 17206864.5
(22) Date de dépôt: 13.12.2017
(51) Int. Cl.: C09J 183/04, H01L 21/02

(54) **COMPOSITION ADHESIVE ET SON UTILISATION DANS L'ELECTRONIQUE**
KLEBSTOFFSZUSAMMENSETZUNG UND IHRE VERWENDUNG IN ELEKTRONIK
ADHESIVE COMPOSITION AND USE THEREOF IN ELECTRONICS

(30) Priorité: 20.12.2016 FR 1662808
(43) Date de publication de la demande: 27.06.2018
(73) Titulaire: Commissariat à l'Energie Atomique et aux Energies Alternatives, 75015 Paris (FR)
(72) Inventeur: ROUMANIE, Maryline, 38500 COUBLEVIE (FR); FLASSAYER, Cécile, 38760 VARCES-ALLIERES-ET-RISSET (FR); LAUCOURNET, Richard, 38500 LA BUISSE (FR)
(74) Mandataire: Cabinet Laurent & Charras

(56) Documents cités:
- EP-A1- 1 014 452
- WO-A2-2009/003029
- CN-A- 102 153 955
- FR-A1- 2 455 074
- JP-A- 2010 248 348
- US-A1- 2011 031 519

## Description

### DOMAINE DE L'INVENTION

La présente invention concerne une composition adhésive thermiquement conductrice et électroniquement isolante.

Le domaine d'utilisation de la présente invention concerne notamment la micro électronique et plus particulièrement les procédés de transfert de couches.

### ETAT ANTERIEUR DE LA TECHNIQUE

En raison des procédés mis en œuvre, la fabrication de dispositifs micro électroniques peut nécessiter un adhésif utilisable sur une grande plage de températures. En outre, il est préférable que ce type d'adhésif présente des propriétés spécifiques en termes de conduction thermique et/ou d'isolation électrique.

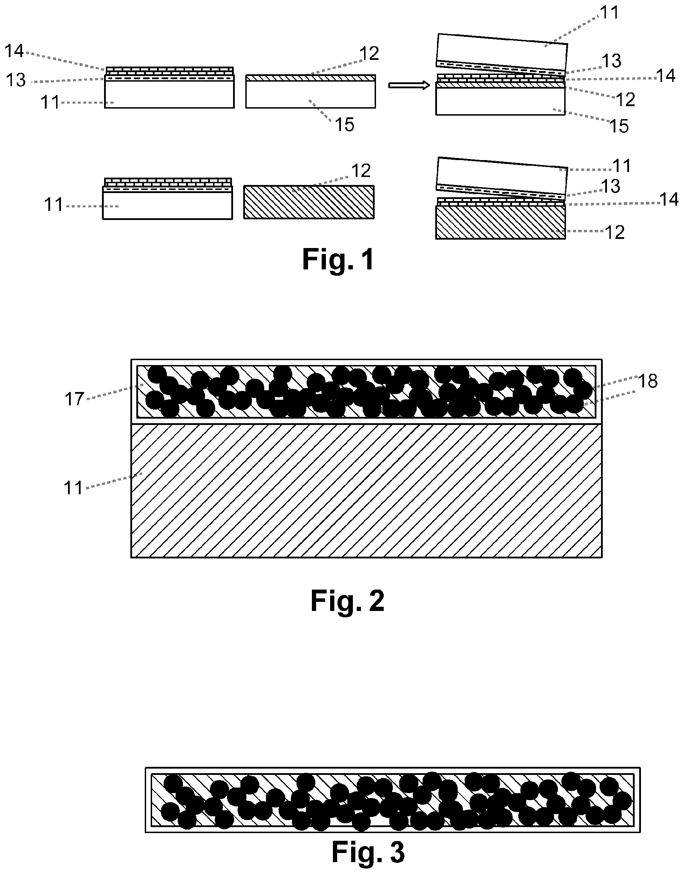

Plus particulièrement, la fabrication d'un dispositif micro électronique peut comprendre la fabrication d'une ou plusieurs couches (14) sur un substrat initial (11), puis le transfert sur un substrat final (12) reposant éventuellement sur un porte substrat (15), et ce au moyen d'un adhésif (13) (figure 1).

Il est ainsi possible de réaliser une architecture complexe sur un substrat pouvant résister aux conditions de fabrication avant de transférer cette architecture sur un substrat plus fragile.

La présence d'un adhésif peut s'avérer nécessaire pour assurer le transfert entre le substrat initial et le substrat final.

De manière générale, les adhésifs polymériques utilisés sont des acryliques, des uréthanes, des silicones, des polyimides ou des époxys car ils présentent les propriétés thermiques et/ou électriques requises.

A titre d'exemple, les documents US 2013/0221479 et US 2012/0086100 décrivent l'utilisation d'un adhésif thermoplastique à base acrylique ou polyimide pour lier un substrat de type saphir sur un dispositif électronique.

Des adhésifs composites ont également été développés. Par exemple, le document US 2014/0252566 décrit un mélange contenant un adhésif polymérique et des charges ainsi que son utilisation dans la fabrication d'un semi-conducteur. L'adhésif peut être de type polyamide, ABS (acrylonitrile butadiène styrène), PEEK (polyétheréthercétone), polysulfone ou une résine époxy.

Un autre type d'adhésif composite a été décrit par Xu et al. (Composites : Part A applied science and manufacturing, 2001, 32(12), pages 1749-1757). Cet adhésif comprend des charges de nitrure d'aluminium dans une matrice époxy ou poly(fluorure de vinylidène).

Le document CN 102 153955 porte sur une maille en fibres de verre comprenant une composition qui comporte un composé siliconé, du tétrahydrofuranne, un sesquioxyde d'aluminium et des particules d'AlN. Le document FR 2 455 074 décrit des compositions adhésives à base de silicones qui comportent des charges céramifiables, utilisées pour préparer des matériaux composites.

Quand bien même les adhésifs existants peuvent s'avérer satisfaisants, leur température d'utilisation n'est pas optimale. En outre, certains d'entre eux se présentent sous la forme de granulés, rendant leur mise en œuvre fastidieuse dans le domaine de la microélectronique.

En effet, les températures utilisées pour fabriquer des dispositifs microélectroniques peuvent s'avérer incompatibles avec certains adhésifs en raison de leur dégradation ou de leur décomposition à haute température, ce qui limite leur utilisation. La température d'utilisation des adhésifs conventionnellement utilisés est la suivante :
- acryliques : -65 à 125°C,
- uréthanes : -40 à 125°C,
- silicones : -50 à 300°C,
- polyimides : -140 à 225°C (-260 à 400°C pour le Kapton®),
- époxys : -55 à 200°C.

Outre la résistance à des températures compatibles avec la fabrication d'un dispositif microélectronique, ces adhésifs doivent également présenter une conductivité thermique satisfaisante.

Le Demandeur a mis au point une composition adhésive présentant les propriétés adéquates pour une utilisation dans la microélectronique, que ce soit en termes de stabilité sur une grande plage de températures, de conduction thermique ou d'isolation électrique.

### EXPOSE DE L'INVENTION

La présente invention concerne une composition adhésive dont les propriétés permettent son utilisation dans la fabrication de dispositifs microélectroniques.

Il s'agit d'une composition adhésive conductrice thermique, isolante électrique, réticulable à basse température et pouvant être utilisée à une température de 350°C ou plus, alors que les colles conventionnelles se dégradent ou se décomposent à ces températures. En outre, elle présente une conductivité thermique avantageusement d'au moins 2 W/m.K.

Plus précisément, la présente invention concerne une composition adhésive comprenant :
- au moins un polymère précéramique à base de silicium tel que revendiqué,
- un ou plusieurs types de charges inorganiques thermiquement conductrices et électriquement isolantes dont la nature et la quantité sont telles que revendiquées,
- au moins un solvant organique.

Le polymère précéramique présente une tenue en température avantageusement supérieure à 350°C, ce qui permet de le transformer à haute température en céramique. Ainsi, avantageusement, la composition adhésive selon l'invention présente une stabilité thermique au-delà de 250°C.

La tenue en température des silicones étant nettement inférieure à 350°C, les résines de type silicone-polyimide ne correspondent pas à la composition adhésive selon l'invention ni à des polymères précéramiques.

De manière avantageuse, la composition adhésive présente un coefficient de dilatation thermique faible à la température d'utilisation, avantageusement moins de 20 ppm/°C à 250°C, plus avantageusement de l'ordre de 10 ppm/°C à 250°C. En outre, et également de manière avantageuse, le coefficient de dilatation thermique n'évolue plus après un traitement à 250°C, notamment après des dizaines d'heures à 250°C, par exemple après 168 heures à 250°C. Ainsi, une stabilisation thermique peut être obtenue au-delà de 250°C. Au contraire, les silicones de l'art antérieur se dégradent généralement à 250°C ou plus et présentent un coefficient de dilatation thermique qui peut varier de 30 à 300 ppm/°C.

Dans la pratique, cette composition adhésive est déposée sur un substrat avant d'être séchée, et éventuellement traitée thermiquement. Il en résulte une couche adhésive qui correspond donc à la composition adhésive qui a été séchée et éventuellement traitée thermiquement.

Conformément à l'invention, la composition adhésive comprend au moins un polymère précéramique, avantageusement à base de silicium. Il s'agit d'un polymère constituant un précurseur de céramique, par exemple SiO₂ dans le cas d'un polymère précéramique à base de silicium.

En d'autres termes, un polymère précéramique est susceptible de se transformer en tout ou partie en une céramique lorsqu'il est soumis à un traitement thermique. En fonction de la céramique désirée, ce traitement thermique peut être réalisé sous air ou non.

Le polymère précéramique est choisi dans le groupe comprenant les polysiloxanes, les polysilsesquioxanes, les polycarbosiloxanes, les polyborosilanes, les polyborosiloxanes, les polysilazanes, les polysilsesquiazanes, les polyborosilazanes, les polycarbosilanes, les polysilylcarbodiimides, et les polysilsesquicarbodiimides.

De manière préférentielle, le polymère précéramique est un polysiloxane, avantageusement un polysiloxane comprenant un ou plusieurs motifs répétitifs siloxanes, dans lesquels l'atome de silicium est lié de manière covalente aux groupes R¹ et R² selon la formule (I) suivante : 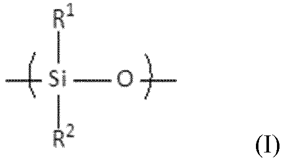 Dans la formule (I), R¹ et R² représentent avantageusement, et indépendamment l'un de l'autre, un atome d'hydrogène, ou un groupe alkyle, ou un groupe aromatique, à condition que l'un au moins des groupes R¹ et R² représente un groupe alkyle.

Selon un mode de réalisation particulier de l'invention, R¹ et R² peuvent représenter, tous les deux, un groupe alkyle, avantageusement le même groupe alkyle.

Selon un autre mode de réalisation particulier, le polymère précéramique peut être un polysiloxane de formule -(SiR¹R²-X)- avec X = O, C, B ou N (C, B et N étant généralement substitués).

De manière avantageuse, le ou les groupes alkyles du motif siloxane selon la formule (I) comprennent 1 à 4 atomes de carbone. Il s'agit avantageusement de groupements choisis dans le groupe comprenant méthyle, éthyle, propyle, isopropyle, *n*-butyle, isobutyle et *tert*-butyle ; le groupe méthyle étant particulièrement préféré. Aussi, R¹ et R² représentent avantageusement un groupe méthyle.

De manière avantageuse, le ou les groupes aromatiques du motif siloxane selon la formule (I) comprennent 6 à 9 atomes de carbone. Il s'agit avantageusement des groupes phényle, benzyle, *o*-tolyle, *m*-tolyle, *p*-tolyle, *o*-xylyle et mésityle ; le groupe phényle étant particulièrement préféré.

Outre le ou les motifs répétitifs siloxanes selon la formule (I), le polymère précéramique peut comprendre d'autres types de motifs répétitifs siloxanes. Dans ce cas, le ou les motifs répétitifs siloxanes selon la formule (I) représente(nt) avantageusement plus de 50% en masse de la masse du polymère précéramique.

Le polymère précéramique peut également être un composé organique/inorganique contenant aussi bien la structure de base de la céramique désirée qu'un environnement périphérique organique offrant différentes fonctionnalités.

En outre, le polymère précéramique est avantageusement réticulable.

De manière générale, un polymère précéramique à base de silicium est susceptible de former de la silice SiO₂ lorsqu'il est soumis à un traitement thermique, éventuellement en présence d'oxygène.

Ainsi, le polymère précéramique peut comprendre un motif répétitif de formule (I), avec préférentiellement R¹=R²=CH₃, et présenter une capacité à former, après céramisation (oxydation complète) au moins 80% en masse de silice SiO₂ par rapport à la masse totale du polymère solide subsistant après l'oxydation complète.

Il peut notamment s'agir du polymère précéramique Silres® MK commercialisé par la société Wacker. Ce polymère présente une aptitude élevée de formation de silice (environ 82% en masse par rapport à la masse totale du polymère solide subsistant après l'oxydation complète).

En outre, le polymère précéramique est avantageusement soluble dans de nombreux solvants organiques, tels que des solvants aromatiques, des solvants esters, ou des solvants cétones.

De manière avantageuse, le polymère précéramique représente 15 à 50% en masse par rapport à la masse totale de la composition adhésive, plus avantageusement 25 à 35% en masse.

Comme déjà indiqué, la composition adhésive selon l'invention comprend également un ou plusieurs types de charges inorganiques.

Les charges inorganiques (ci-après « les charges ») sont thermiquement conductrices et électriquement isolantes.

Il s'agit de charges choisies dans le groupe comprenant AlN ; Al₂O₃ ; hBN (nitrure de bore hexagonal) ; nitrure de silicium ; les céramiques à base de silicium, aluminium, oxygène et azote par exemple le sialon ; et BeO.

Sans être lié à une quelconque théorie, le Demandeur considère que la présence de charges inorganiques permet d'augmenter l'épaisseur de la couche adhésive déposée grâce à une augmentation de la viscosité de la composition. Elle permet, en outre, de prévenir les risques de fissuration lors d'un éventuel traitement thermique de la composition adhésive. Finalement, la présence des charges permet d'obtenir un réseau percolant et ainsi de contrôler la conductivité thermique c'est-à-dire les propriétés de conduction thermique de la composition adhésive.

Ainsi, il est possible de moduler les propriétés de la composition adhésive en fonction de la nature et/ou de la quantité de charges. Ces propriétés peuvent également être modulées par la présence de charges de formes différentes et/ou de tailles différentes et/ou par la fonctionnalisation des charges.

Les charges peuvent notamment se présenter sous la forme de sphères, de fils, de bâtonnets, et leurs combinaisons.

La taille des charges est généralement comprise entre quelques nanomètres et plusieurs dizaines de micromètres. Elle dépend généralement de l'épaisseur de couche adhésive souhaitée (composition adhésive déposée). En d'autres termes, la taille des charges est avantageusement proportionnelle à l'épaisseur de la couche de composition adhésive déposée. Aussi, afin d'optimiser la densité de la composition adhésive, un empilement compact de charges est souhaitable. Pour cela, il est avantageux d'utiliser un mélange des charges de différentes tailles, par exemple un mélange de 3 tailles de charges.

Comme déjà indiqué, les charges peuvent être fonctionnalisées. Ce mode de réalisation particulier permet d'améliorer l'homogénéité de la composition adhésive. Plus particulièrement, la fonctionnalisation des charges permet d'améliorer leur mouillabilité dans la composition adhésive. Une meilleure mouillabilité se traduit notamment par l'élimination d'éventuelles bulles de gaz (par exemple de l'air) autour des charges.

Les charges peuvent notamment être fonctionnalisées avec des composés choisis parmi l'APTES (3-aminopropyltriéthoxysilane), le glymo ((3-glycidyloxypropyl) triméthoxysilane), ou tout type de silanes compatible avec la charge et le polymère précéramique.

La fonctionnalisation des charges avec l'APTES ou le GLYMO est particulièrement adaptée pour un polymère précéramique à base de silicium, par exemple un polysiloxane.

Les charges représentent entre 60%vol (pourcentage volumique) et 80%vol, par rapport au volume total du polymère précéramique et des charges, plus avantageusement entre 65 et 80%vol, et encore plus avantageusement entre 65 et 75%vol.

Une quantité de charges inférieure à 60%vol diminue la conductivité thermique de la composition adhésive en raison de l'augmentation de la quantité de polymère précéramique non conducteur thermique. En revanche, une quantité de charges supérieure à 80%vol diminue les propriétés adhésives de la composition adhésive, les charges n'étant pas intégralement enrobées par la composition adhésive. D'autre part, une quantité trop importante de charges par rapport à la composition adhésive engendre la formation de pores, et donc une diminution de la conductivité thermique liée à la présence de bulles de gaz (par exemple de l'air) dans la composition adhésive. De manière avantageuse, les charges représentent 52 à 75% en masse par rapport à la masse totale de la composition adhésive, plus avantageusement 58 à 75% en masse.

Le rapport massique entre le polymère précéramique et les charges inorganiques est avantageusement compris entre 1:4 et 1:11, plus avantageusement 1:5 à 1:11 en masse.

Enfin, la composition adhésive comprend au moins un solvant organique. Ce solvant est avantageusement un solvant polaire aprotique, par exemple un solvant organique choisi dans le groupe comprenant les cétones, les esters, les éthers, les solvants aromatiques (comme les hydrocarbures aromatiques), les solvants halogénés (comme le chloroforme) et les mélanges de ceux-ci. Le solvant peut également être un alcane, par exemple l'hexane, notamment lorsque le polymère précéramique est un polysiloxane.

Plus spécifiquement, la composition peut comprendre, comme solvant organique :
- un solvant de type hydrocarbure aromatique, avantageusement le xylène, ou
- un solvant cétonique spécifique, avantageusement la butan-2-one (également connue sous l'appellation méthyléthylcétone) ; ou
- un mélange d'éther monométhylique de propylène glycol, d'acétate de 2-méthoxy-1-méthyléthyle, d'alcanes et de composés aromatiques, par exemple un solvant référencé sous la marque Diestone ®.

Le solvant organique représente avantageusement 15 à 35% en masse par rapport à la masse de la composition adhésive, plus avantageusement 15 à 30% en masse.

De manière avantageuse, la composition adhésive comprend également un agent de couplage Cet agent de couplage permet de faciliter la réticulation du polymère précéramique, la liaison entre le substrat et la couche adhésive (résultant du dépôt de la composition adhésive), de réduire la viscosité de la suspension, et d'améliorer la qualité de la dispersion des charges inorganiques.

L'agent de couplage peut être choisi dans le groupe comprenant le (3-glycidyloxypropyl) triméthoxysilane (référence commerciale Dynasylan® GLYMO), le N-(2-aminoéthyl)-3-aminopropyltriméthoxysilane, et le 3-méthacryloxypropyl triméthoxysilane. Ces composés sont particulièrement adaptés lorsque le polymère précéramique est un polysiloxane.

L'agent de couplage, lorsqu'il est présent, peut représenter 0,1 à 2% en masse par rapport à la masse totale du polymère précéramique.

En fonction de la nature de l'éventuel traitement thermique qu'elle subit après avoir été déposée, la composition adhésive peut comprendre d'autres additifs.

En effet, lorsque, l'étape de séchage est suivie par une étape de réticulation du polymère précéramique, la composition adhésive comprend avantageusement un catalyseur de réticulation du polymère précéramique.

Ce catalyseur permet d'abaisser la température de réticulation du polymère précéramique. Il peut être choisi parmi les sels métalliques, par exemple des sels de platine, d'étain, d'aluminium ou de ziconium ; les composés organostanneux ; les composés peroxydes ; et les composés amines. Ces composés sont particulièrement adaptés pour réticuler un polymère précéramique de type polysiloxane.

Le catalyseur de réticulation peut notamment être choisi dans le groupe comprenant la triéthanolamine, l'acétate de tétrabutylammonium, l'acétylacétonate d'aluminium, l'acétylacétonate de ziconium, et l'acétylacétonate de platine.

Le catalyseur de réticulation peut représenter 0 à 2% en masse par rapport à la masse de polymère précéramique.

Comme déjà indiquée, lors de son utilisation, la composition adhésive est généralement déposée sur un substrat.

Aussi, la présente invention concerne également un procédé de préparation d'une couche adhésive par dépôt de la composition adhésive sur un substrat.

La présente invention concerne également la couche adhésive résultant du dépôt de la composition adhésive, son séchage et son éventuel traitement thermique. Le traitement thermique peut permettre la réticulation et/ou la céramisation du polymère précéramique. Le séchage (élimination du solvant organique) peut être réalisé par traitement thermique entrainant également la réticulation et/ou la céramisation du polymère précéramique.

Le séchage permet d'éliminer le solvant organique alors que le traitement thermique, avantageusement sous air, permet la réticulation en tout ou partie et/ou la céramisation en tout ou partie du polymère précéramique.

Ainsi, la couche adhésive peut être constituée de la composition adhésive séchée. Elle peut comprendre au moins un polymère précéramique réticulé et/ou céramisé. La réticulation du polymère précéramique et sa céramisation peuvent être partielles ou, préférentiellement, totales.

La couche adhésive comprend avantageusement :
- un polymère précéramique céramisé et des charges inorganiques thermiquement conductrices et électriquement isolantes, ou
- un polymère précéramique réticulé et des charges inorganiques thermiquement conductrices et électriquement isolantes.
- un polymère précéramique réticulé et céramisé et des charges inorganiques thermiquement conductrices et électriquement isolantes.

Le rapport massique entre la céramique polymère ou le polymère précéramique réticulé et les charges inorganique est avantageusement compris entre 1:4 et 1:11, plus avantageusement 1:5 à 1:11 en masse.

La présence des charges lors de la réticulation et/ou la céramisation du polymère précéramique permet d'obtenir une couche adhésive homogène dans laquelle les charges sont réparties au sein du polymère ou de la céramique.

Comme la composition adhésive comprend un solvant organique et, de ce fait présente un caractère liquide, elle peut être déposée par toutes techniques de dépôt par voie liquide, lesquelles techniques de dépôt seront choisies en fonction de l'épaisseur de couche adhésive souhaitée.

Ainsi, la composition peut être déposée par étalement à la racle. Cette technique est particulièrement adaptée pour un dépôt sur une surface plane, par exemple sur un substrat semi-conducteur de type wafer, et pour l'obtention d'un dépôt dont l'épaisseur peut atteindre 300 µm. Cette technique peut également permettre de former une couche de composition adhésive autosupportée.

La composition adhésive peut également être déposée par pulvérisation (connue sous l'appellation anglo-saxonne « *spray coating* »). Cette technique est particulièrement adaptée pour réaliser un dépôt dont l'épaisseur est comprise entre 15 et 20 µm.

D'autres modes de réalisation consistent à déposer la composition adhésive par impression, notamment par sérigraphie, ou par enduction par centrifugation (« spin coating »).

L'homme du métier saura adapter la technique de dépôt en fonction de l'épaisseur souhaitée, mais aussi en fonction de la géométrie du substrat à recouvrir.

Préalablement à l'étape de dépôt, le procédé de l'invention peut comprendre une étape de préparation de la composition définie ci-dessus, cette étape de préparation consistant, classiquement, à mettre en contact les différents ingrédients constitutifs de la composition et à les mélanger jusqu'à obtenir un mélange homogène.

Après l'étape de dépôt, le procédé de l'invention comprend une étape de traitement thermique consistant à sécher ladite composition.

Le séchage consiste en l'élimination du ou des solvants organiques par évaporation, ne laissant ainsi subsister qu'une couche consistant en un matériau composite comprenant un polymère précéramique, un ou plusieurs types de charges inorganiques à propriétés de conducteur thermique et d'isolant électrique et, éventuellement, au moins un additif tel qu'un agent de couplage et/ou un catalyseur de réticulation.

Pour sa mise en œuvre, le séchage peut consister à laisser la composition ainsi déposée sécher à l'air libre ou encore à appliquer un chauffage à une température et pendant une durée appropriées pour entraîner l'évaporation du ou des solvants organiques. Le traitement choisi dépend de la nature du ou des solvants organiques utilisés et de leurs températures d'évaporation respectives.

Comme déjà indiqué, après l'étape de séchage, le procédé selon l'invention peut comprendre une étape de traitement thermique consistant à réticuler et/ou à céramiser le polymère précéramique.

La réticulation se matérialise par la création de ponts chimiques entre les chaînes macromoléculaires du polymère précéramique. Cela se traduit par une augmentation de liaisons intermoléculaires, de type -Si-X- dans cas d'un polymère précéramique à base de silicium (X = Si, O, C, N ou B), au sein de la couche adhésive et ainsi par un durcissement de celle-ci. En outre, la réticulation permet d'augmenter la cohésion et la résistance mécanique de la couche adhésive. Elle permet également d'améliorer son adhérence au substrat qui peut notamment être en silicium. Il est ainsi possible d'utiliser la composition adhésive dans des procédés de transfert de couches couramment mis en œuvre dans le domaine de la microélectronique. Cela permet aussi d'améliorer la conductivité thermique du système.

La composition adhésive est préférablement réticulée à une température inférieure ou égale à 200°C. Comme déjà indiqué, la présence d'un catalyseur de réticulation permet d'abaisser cette température.

De manière générale, la réticulation peut être réalisée dans un four pour que la répartition de chaleur soit uniforme.

Elle peut également être réalisée au moyen d'une thermopresse afin de compresser à chaud pour améliorer la cohésion de la couche adhésive et donc augmenter la conductivité thermique. L'utilisation d'une thermopresse permet aussi d'améliorer l'état de surface de la composition adhésive en abaissant sa rugosité.

Selon un mode de réalisation particulier, le procédé peut être finalisé par une étape de céramisation du polymère précéramique, par exemple en SiO₂ lorsque le polymère précéramique est à base de silicium. Cette étape de céramisation est avantageusement réalisée après ou simultanément à une étape de réticulation. Cette spécificité du polymère précéramique permet d'englober tous les budgets thermiques issus des procédés de microélectronique.

La présente invention concerne également une couche adhésive préparée à partir de la composition adhésive décrite ci-avant ; un support adhésif constitué d'un substrat et de cette couche adhésive ; et l'utilisation de cette couche adhésive et de ce support adhésif dans le domaine de la microélectronique, notamment dans un procédé de transfert de couche.

Le substrat sur lequel est déposée la composition adhésive peut être en silicium ou en silice par exemple.

Comme déjà indiqué, l'homme du métier saura adapter la technique de dépôt en fonction de l'épaisseur souhaitée, mais aussi en fonction de la géométrie du substrat à recouvrir.

En outre, il saura ajuster la quantité de solvant pour faciliter la mise en forme de la composition adhésive selon l'invention.

L'invention et les avantages qui en découlent ressortiront mieux des figures et exemples suivants donnés afin d'illustrer l'invention et non de manière limitative.

### DESCRIPTION DES FIGURES

La figure 1 illustre deux procédés conventionnels de transfert de couches entre deux substrats.
La figure 2 illustre un support adhésif obtenu après le dépôt de la composition adhésive selon l'invention sur un substrat en silicium ou en silice.
La figure 3 illustre un support adhésif obtenu après le dépôt de la composition adhésive selon l'invention.
La figure 4 représente des photographies de couches obtenues après le dépôt de la composition adhésive selon l'invention sur un substrat en silicium ou en silice après réticulation à 200°C.
La figure 5 représente des photographies de couches obtenues après dépôt de la composition adhésive selon l'invention sur un substrat en silicium ou en silice après un traitement thermique à 350°C pendant 30 minutes.
La figure 6 illustre la conductivité thermique en fonction de la quantité de charges pour des compositions adhésives selon l'invention.
La figure 7 correspond à l'agrandissement d'une partie de la figure 6.

### EXEMPLES DE REALISATION DE L'INVENTION

### Préparation d'échantillons

Plusieurs exemples de compositions adhésives selon l'invention ont été préparés. Pour cela, les composants suivants sont mélangés avant l'application de la composition adhésive sur un substrat :
- 15 à 30%vol d'un polysiloxane à fort taux de conversion en silice (référence Silres®MK de chez Wacker) ;
- 60 à 85%vol d'une ou plusieurs charges inorganiques ;
- un solvant de type xylène.

Les pourcentages volumiques sont exprimés par rapport au volume total de la composition adhésive à l'exception du solvant organique.

Les charges inorganiques utilisées sont des charges conductrices thermiques et isolantes électriques avec des granulométries différentes.

La composition adhésive est homogénéisée de manière à répartir les charges inorganiques (18) au sein du polymère précéramique (17) (figures 2 et 3). Elle est ensuite déposée par étalement à la racle sur un substrat (11) en silicium ou en silice (figure 2). Elle peut également être utilisée seule, c'est-à-dire sans substrat (figure 3).

Le dépôt sans substrat permet de réaliser des échantillons pour la mesure de la conductivité thermique. Il permet également de réaliser un substrat en composition adhésive, sans support.

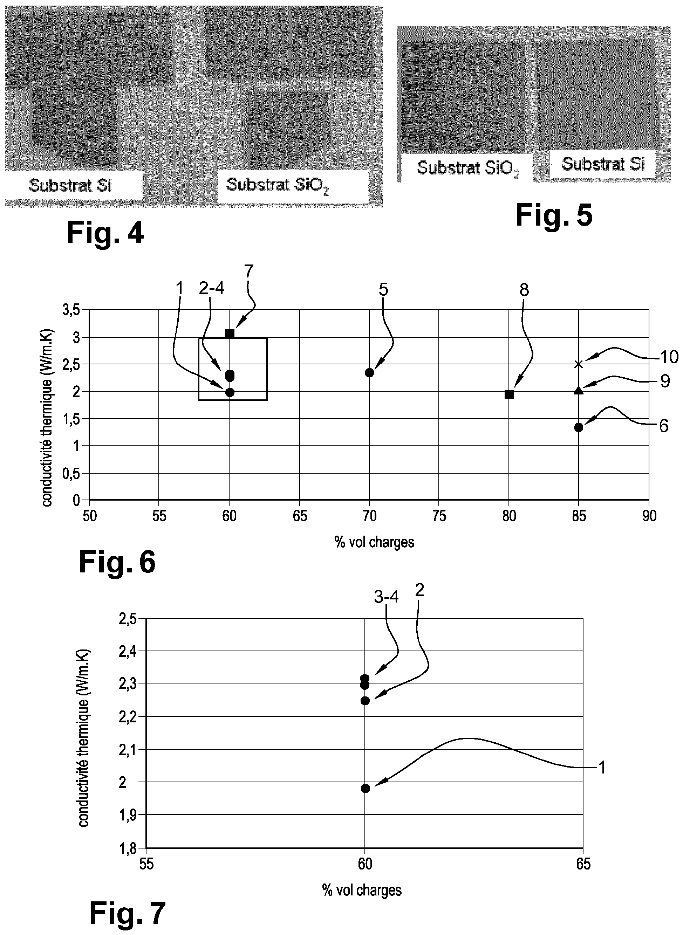

Une couche adhésive est obtenue après évaporation du solvant. Il est réticulé, par exemple par traitement thermique à 200°C pendant 30 minutes (figure 4).

**Tableau 1 : exemples de réalisation de la composition adhésive selon l'invention.**

| Exemple | 1 | 2 | 3 | 4 | 5 | 6 | 7 | 8 | 9 | 10 |
|---|---|---|---|---|---|---|---|---|---|---|
| Charges | C1 | C1 | C2 | C2 | C1 | C1 | C3 | C3 | C4 | C5 |
| (%vol) | (60) | (60) | (60) | (60) | (70) | (85) | (60) | (80) | (85) | (85) |
| Polymère | P1 | P1 | P1 | P1 | P1 | P1 | P1 | P1 | P1 | P1 |
| (%vol) | (40) | (40) | (40) | (40) | (30) | (15) | (40) | (20) | (15) | (15) |

| | | | | | | | | | | |
|---|---|---|---|---|---|---|---|---|---|---|
| C1: charges d'AlN (d50 = 0.125µm) C2: charges fonctionnalisées d'AlN (d50 = 0.125µm) C3: charges d'AlN (1/ d50 = 0.7-1 1µm ; 2/ d50 = 2-4.5µm : 3/ d50 = 0.8-2µm) C4: mélange de charges d'AlN (d50 = 7.5µm) et de charges nanométriques d'AlN C5: mélange de charges C1 + C4 P1: polysiloxane Silres®MK de chez Wacker | | | | | | | | | | |

Les pourcentages volumiques sont exprimés par rapport au volume total de la composition adhésive à l'exception du solvant organique.

La composition adhésive selon l'exemple 2 a subi un traitement thermique à 350°C pendant 30 minutes.

Les figures 6 et 7 illustrent la conductivité thermique de ces compositions adhésives.

### Tests thermiques

Les couches obtenues par dépôt des compositions adhésives selon les exemples 1 à 10 ont été testées après un traitement thermique à 350°C pendant 30 minutes dans un four sous air (figure 5). A l'issue de ce traitement thermique, aucune fissure n'est observée sur les couches.

Des tests ont aussi été réalisés à 450°C, après une réticulation à 200°C. Dans ce cas, les dépôts apparaissent également sans fissures.

Des tests ont également été réalisés à 350°C, après une réticulation à 150°C. Dans ce cas, les dépôts apparaissent également sans fissures.

Aucune dégradation n'est observée à l'issue ces différents traitements thermiques.

En outre, la force de collage sur un substrat en silicium a été mesurée après ces traitements thermiques. Elle est de l'ordre de 7 à 8 MPa, ce qui est équivalent, voire supérieur aux colles époxy conventionnelles.

### Conductivité thermique

Les figures 6 et 7 montrent que la conductivité thermique des couches obtenues par dépôt des compositions adhésives selon les exemples 1 à 10 peut être contrôlée en fonction des paramètres suivants :
- la fonctionnalisation des charges qui améliore la mouillabilité des charges dans la composition adhésive,
- un traitement thermique de la composition adhésive à une température supérieure à la température de réticulation qui permet de densifier le réseau et favorise la percolation,
- la granulométrie des charges,
- la quantité de charges.

## Revendications

1. Composition adhésive comprenant un polymère, des charges inorganiques, et au moins un solvant organique, dans laquelle :
- le polymère est au moins un polymère précéramique, à base de silicium,
- les charges comprennent un ou plusieurs types de charges inorganiques thermiquement conductrices et électriquement isolantes,
le polymère précéramique étant choisi dans le groupe comprenant les polysiloxanes, les polysilsesquioxanes, les polycarbosiloxanes, les polyborosilanes, les polyborosiloxanes, les polysilazanes, les polysilsesquiazanes, les polyborosilazanes, les polycarbosilanes, les polysilylcarbodiimides, et les polysilsesquicarbodiimides,
les charges inorganiques étant choisies dans le groupe comprenant AlN ; Al₂O₃ ; hBN ; nitrure de silicium ; les céramiques à base de silicium, aluminium, oxygène et azote ; et BeO,
les charges inorganiques représentent 60 à 80% en volume, par rapport au volume total de la composition adhésive.

2. Composition adhésive selon la revendication 2, ***caractérisée* en ce que** le polymère précéramique représente 15 à 50% en masse, par rapport à la masse totale de la composition adhésive.

3. Composition adhésive selon l'une des revendications 1 à 2, ***caractérisée* en ce que** la composition adhésive présente des charges inorganiques de tailles différentes et/ou de formes différentes.

4. Composition adhésive selon l'une des revendications 1 à 3, ***caractérisée* en ce que** la composition adhésive présente un rapport massique entre le polymère précéramique et les charges inorganique compris entre 1:4 et 1:11, avantageusement 1:5 à 1:11 en masse.

5. Couche adhésive constituée de la composition adhésive, séchée, selon l'une des revendications 1 à 4.

6. Couche adhésive selon la revendication 5, ***caractérisée* en ce qu'**elle comprend au moins un polymère précéramique réticulé et/ou céramisé.

7. Utilisation de la couche adhésive selon la revendication 5 ou 6 dans le domaine de la microélectronique, dans un procédé de transfert de couche.

## Patentansprüche

1. Klebstoffzusammensetzung mit einem Polymer, anorganischen Füllstoffen und mindestens einem organischen Lösungsmittel, in der:
- das Polymer mindestens ein vorkeramisches Polymer auf Siliziumbasis ist.
- die Füllstoffe einen oder mehrere anorganische Füllstoffe vom wärmeleitenden und elektrisch isolierenden Typ umfassen,
das präkeramische Polymer wird ausgewählt aus der Gruppe zu der die Polysiloxane, Polysilsesquioxane, Polycarbosiloxane, Polyborosilane, Polyborosiloxane, Polysilazane, Polysilsesquiazane, Polyborosilazane, Polycarbosilane, Polysilylcarbodiimide und Polysilsesquicarbodiimide gehören, die anorganischen Füllstoffe werden ausgewählt aus der Gruppe, zu der AIN; Al₂O₃; hBN; Siliziumnitrid; Keramik auf Basis von Silizium, Aluminium, Sauerstoff und Stickstoff; sowie BeO, gehören,
die anorganischen Füllstoffe bilden 60 bis 80 Volumen-% bezogen auf das Gesamtvolumen der Klebstoffzusammensetzung.

2. Klebstoffzusammensetzung gemäß Anspruch 2, ***dadurch gekennzeichnet, dass*** das präkeramische Polymer 15 bis 50 Masse-% bezogen auf die Gesamtmasse der Klebstoffzusammensetzung bildet.

3. Klebstoffzusammensetzung gemäß einem der Ansprüche 1 bis 2, ***dadurch gekennzeichnet, dass*** die Klebstoffzusammensetzung anorganische Füllstoffe unterschiedlicher Größe und/ oder unterschiedlicher Form aufweist.

4. Klebstoffzusammensetzung gemäß einem der Ansprüche 1 bis 3, ***dadurch gekennzeichnet, dass*** die Klebstoffzusammensetzung ein Masseverhältnis zwischen dem präkeramischen Polymer und den anorganischen Füllstoffen zwischen 1:4 und 1:11 aufweist, vorteilhafterweise 1:5 bis 1:11 der Masse.

5. Klebeschicht, bestehend aus der getrockneten Klebstoffzusammensetzung nach einem der Ansprüche 1 bis 4.

6. Klebstoffzusammensetzung nach Anspruch 5, ***dadurch gekennzeichnet, dass*** sie mindestens ein vernetztes und/ oder keramisiertes präkeramisches Polymer enthält.

7. Einsatz der Klebstoffzusammensetzung nach Anspruch 5 oder 6 auf dem Gebiet der Mikroelektronik in einem Schichttransferverfahren.

## Claims

1. An adhesive composition comprising a polymer, inorganic fillers, and at least one organic solvent, wherein:
- the polymer is at least one preceramic polymer, based on silicon,
- the fillers comprise one or a plurality of types of thermally conductive and electrically insulating inorganic fillers,
the preceramic polymer being selected from the group comprising polysiloxanes, polysilsesquioxanes, polycarbosiloxanes, polyborosilanes, polyborosiloxanes, polysilazanes, poly-silsesquiazanes, polyborosilazanes, polycarbosilanes, polysilylcarbodiimides, and polysilsesquicarbodiimides,
the inorganic fillers being selected from the group comprising AlN; Al₂O₃; hBN; silicon nitride; ceramics based on silicon, aluminum, oxygen, and nitrogen; and BeO,
the inorganic fillers representing from 60 to 80 vol.% with respect to the total volume of the adhesive composition.

2. The adhesive composition of claim 1, ***characterized* in that** the preceramic polymer represents from 15 to 50 wt.% with respect to the total weight of the adhesive composition.

3. The adhesive composition of any of any of claims 1 to 2, ***characterized* in that** the adhesive composition comprises inorganic fillers having different sizes and/or different shapes.

4. The adhesive composition of any of claims 1 to 3, ***characterized* in that** the adhesive composition has a weight ratio of the polymer ceramic or the crosslinked preceramic polymer to the inorganic fillers in the range from 1:4 to 1:11, more advantageously from 1:5 to 1:11 by weight.

5. An adhesive layer formed of the adhesive composition, dried, of any of claims 1 to 4.

6. The adhesive layer of claim 5, ***characterized* in that** it comprises at least one crosslinked and/or ceramized preceramic polymer.

7. A use of the adhesive layer of claim 5 or 6 in microelectronics, in a layer transfer method.
